# EUROPEAN PATENT SPECIFICATION

(11) **EP 2 122 668 B1**
(45) Date of publication and mention of the grant of the patent: **04.07.2018**
(21) Application number: 08720195.0
(22) Date of filing: 17.01.2008
(51) Int. Cl.: H01L 21/20

(54) **SEMICONDUCTOR SUBSTRATE SUITABLE FOR THE REALISATION OF ELECTRONIC AND/ OR OPTOELECTRONIC DEVICES AND RELATED MANUFACTURING PROCESS**
HALBLEITERSUBSTRAT ZUR HERSTELLUNG ELEKTRONISCHER UND/ODER OPTOELEKTRONISCHER BAUELEMENTE UND ENTSPRECHENDES HERSTELLUNGSVERFAHREN
SUBSTRAT EN SEMI-CONDUCTEUR SE PRÊTANT À LA RÉALISATION DE DISPOSITIFS ÉLECTRONIQUES ET/OU OPTOÉLECTRONIQUES ET PROCÉDÉ DE FABRICATION CORRESPONDANT

(30) Priority: 17.01.2007 IT MI20070056
(43) Date of publication of application: 25.11.2009
(73) Proprietor: Consiglio Nazionale delle Ricerche, 00185 Roma (IT)
(72) Inventor: D'ARRIGO, Giuseppe Alessio Maria, I-95121 Catania (IT); LA VIA, Francesco, I-95121 Catania (IT)
(74) Representative: Ferrari, Barbara
(86) International application number: PCT/IT2008/000025
(87) International publication number: WO 2008/087686

(56) References cited:
- EP-A2- 0 969 519
- US-A1- 2004 232 440
- US-A1- 2005 121 693
- US-A1- 2005 161 702
- DALLA TORRE J ET AL: "Beyond the solid on solid model: An atomic dislocation formation mechanism", JOURNAL OF APPLIED PHYSICS, AMERICAN INSTITUTE OF PHYSICS, US, vol. 84, no. 10, 15 November 1998 (1998-11-15), pages 5487-5494, XP012045252, ISSN: 0021-8979, DOI: 10.1063/1.368312
- ROMANOV S I ET AL: "GeSi films with reduced dislocation density grown by molecular-beam epitaxy on compliant substrates based on porous silicon", APPLIED PHYSICS LETTERS, AMERICAN INSTITUTE OF PHYSICS, 2 HUNTINGTON QUADRANGLE, MELVILLE, NY 11747, vol. 75, no. 26, 27 December 1999 (1999-12-27), pages 4118-4120, XP012024346, ISSN: 0003-6951, DOI: 10.1063/1.125555

## Description

### Field of application

The present invention refers to a semiconductive substrate suitable for realising electronic and/or optoelectronic devices.

More specifically, the invention refers to a semiconductive substrate of the type comprising at least one silicon substrate and an overlying layer of single crystal silicon.

The invention also refers to a manufacturing process of such a semiconductive substrate.

### Prior art

In integration technologies on silicon, different methods are known for realising silicon blocks or ingots of large size (up to 300mm in diameter).

Amongst the most well known methods there are, for example, the Czochralski process and the so-called Floating Zone technique through which it is possible to obtain extremely pure silicon blocks, in the form of cylindrical ingots, the basic material for realising so-called wafers for the integration of semiconductor devices.

The aforementioned techniques cannot, however, be used in the case of semiconductive materials alternative to silicon, such as silicon carbide (SiC), gallium nitride (GaN) or aluminium nitride for which there is no liquid phase.

In the past, other different techniques have thus been used to carry out the growth of these semiconductor materials alternative to silicon, nevertheless encountering numerous technological difficulties in the growth of large sized crystals at the same time as a high growth rate and a low presence of defects.

Due to such technological difficulties, semiconductor materials alternative to silicon can currently be grown into smaller sized crystals (from 75 to 100mm in diameter) and at really high costs (for example, a 76mm wafer of silicon carbide (SiC) has a production cost of 500-700$ compared to a production cost of 20$ for the wafer of silicon).

Therefore, there is a great need to define a new technique capable of realising blocks, in particular wafers, of a semiconductive material alternative to silicon. Such blocks must be of a suitable size for the integration of electronic semiconductor devices, in particular larger than the size of the blocks that can currently be made, as well as having lower production costs, so as to be able to be a valid alternative to silicon wafers. A possible solutions consists of using silicon as nucleus for the growth of single crystal blocks or ingots in one of the semiconductor materials alternative to silicon. This method goes by the name heteroepitaxy.

The main problem with such heteroepitaxial growth is the great mismatch between lattices of the crystalline structure of the silicon and of layers made from one of such semiconductor materials alternative to silicon. For example, it is equal to about 25% in the case of silicon carbide (SiC) and to about 20% in the case of gallium nitride (GaN). Such a mismatch has the consequence of the formation of crystallographic defects like the dislocations that allow the relaxation of a film grown by heteroepitaxy. The high densities of such dislocations cause the reduction in breakdown voltage and an increase in leakage current of the semiconductor devices.

The only possibility for obtaining semiconductor devices with good characteristics thus consists of eliminating or at least reducing as much as possible such defects and different methods have been proposed to do so.

A first known method consists of using a buffer layer having a lattice constant that is variable with continuity or a plurality of lattice constants with different values scaled with continuity, starting from a value equal to the lattice constant of silicon up to a value equal to the lattice constant of the used semiconductive material alternative to silicon.

Such a method is described for example in the US patent application No. US 2005/02111988 that describes the use of a substrate of silicon-germanium (SiGe) alloy to "match" the lattice constants involved. Indeed, it has been observed that by using a concentration of germanium close to 7%, the equivalency of five lattice constants of silicon carbide (SiC) is obtained with four lattice constants of silicon-germanium (SiGe) alloy.

However, in this case there is a great difference in the expansion coefficient of the materials used and, consequently, a substantial bow value of the wafer thus obtained, which constitutes a serious problem in using such materials within an integration process of semiconductor devices.

It is thus necessary to increase the germanium percentage used up to 16%, which does, however, introduce a great lattice mismatch between the silicon-germanium (SiGe) alloy and the silicon carbide (SiC).

Similar behaviour is equally described in the patent application indicated above in the case of another semiconductive material alternative to silicon, in other words in the case of gallium nitride (GaN), where to compensate for the difference in the expansion coefficient it is sufficient to use a germanium percentage of 13%, whereas the differences in lattice constant take such a percentage up to 86%.

From US patent application No. US 2005/0287770 a method is also known for directly growing a composite semiconductor (silicon carbide (SiC), gallium arsenide (GaN) or silicide) on a substrate of porous silicon. The use of such a substrate shows a good relaxation of the stress due to the differences between the heat expansion coefficients, leaving the problem of the defects linked to the mismatch of the different crystalline lattices.

Furthermore, the US patent No US 7,101,774 describes an interesting approach aimed at reducing the problems linked to the mismatch of different crystalline lattices.

According to such a patent, a scratched substrate is used to produce a reduction in the planar defects perpendicular to the scratch direction on the surface of the silicon substrate. Such a provision is not however able to reduce other defects, for example the planar defects parallel to the scratch direction defined above.

Moreover, the great difference existing between the heat expansion coefficients of the materials used, in other words - as described in such a patent - silicon and silicon carbide (SiC), leads to a substrate being obtained that is highly stressed and with a high bow value of the wafer, which introduces serious problems, in particular for the photolithographic processes commonly used for the integration of the semiconductor devices.

The technical problem forming the basis of the present invention is to devise a manufacturing process of a semiconductive substrate suitable for the integration of a semiconductor device, having structural and functional characteristics such as to allow to overcome the limitations and drawbacks that the substrates made according to the prior art still suffer from, in particular such as to allow semiconductor materials alternative to silicon to be used.

### Summary of the invention

The idea of solution on the basis of the present invention is to realise a semiconductive substrate comprising a particular surface structure of the substrate itself, capable of completely eliminating the planar defects linked to the mismatch of the crystalline lattices of the materials used, in particular semiconductor materials alternative to silicon, at the same time reducing the stress induced on an epitaxial layer made above such a substrate and the bow value of the semiconductive wafer obtained from such a substrate.

Based upon such an idea of solution, the technical problem is solved by a semiconductive substrate suitable for realising electronic and/or optoelectronic devices of the type comprising at least one silicon substrate and an overlying layer of single crystal silicon, characterised in that it comprises at least one functional coupling layer suitable for reducing the defects linked to the differences in the materials used.

In particular, the functional coupling layer comprises a corrugated portion made in the layer of single crystal silicon and suitable for reducing the defects linked to the differences in lattice constant of such materials used.

In a preferred embodiment, the functional coupling layer comprises a corrugated portion made in the layer of single crystal silicon and suitable for reducing the defects linked to the differences in lattice constant of such materials used and a porous layer arranged between the silicon substrate and the layer of single crystal silicon and suitable for reducing the stress caused by the differences between the thermal expansion coefficients of the materials used.

According to the invention, said corrugated portion comprises a plurality of microstructures made in said layer of single crystal silicon.

In particular, according to an embodiment of the invention, said microstructures are equidistant according to at least one direction between a first and a second direction of extension of said semiconductive substrate.

In particular, said microstructures are equidistant according to said first and second direction of extension of said semiconductive substrate.

Moreover, according to the invention, said microstructures are shaped like an inverse pyramid.

Namely, said microstructures are shaped like a rectilinear pyramid with a square base formed by the planes of the family 111 arranged symmetrically around a central axis having its centre coinciding with a centre of symmetry of a base of said rectilinear pyramid.

According to another embodiment of the invention, said functional coupling layer further comprises a porous layer arranged between said substrate of single crystal silicon and said layer of single crystal silicon and suitable for reducing the stress caused by the differences between the thermal expansion coefficients of the materials used.

According to this embodiment of the invention, said porous layer comprises a layer of porous silicon. Namely, said porous layer consists of a layer with bubbles.

According to another embodiment of the invention, said porous layer has a different porosity between a surface area thereof, positioned at said layer of single crystal silicon and a bottom area thereof, positioned in a position opposite said layer of single crystal silicon.

In particular, according to this embodiment of the invention, said surface area of said porous layer has a porosity equal to 40%-45% and a thickness of the order of a few nanometres and in that said bottom area of said porous layer has greater porosity and thickness than said surface area.

Namely, said bottom area has a porosity equal to 60% and a thickness equal to 10 micron.

Moreover, according to the invention, the semiconductive substrate also comprises a surface layer made above said porous layer.

According to the invention, said surface layer is made from a semiconductive material alternative to silicon.

In particular, said surface layer is made from a material chosen from silicon carbide, gallium nitride, gallium arsenide, zinc selenide and silicon-germanium.

Furthermore, according to an embodiment of the invention, the semiconductive substrate further comprises a silicon buffer layer made between said functional coupling layer and said surface layer.

The problem is also solved by a manufacturing process of a semiconductive substrate suitable for realising electronic and/or optoelectronic devices and comprising the steps of:
- formation of a substrate, in particular of single crystal silicon;
- epitaxial regrowth of a layer of single crystal silicon above said substrate of single crystal silicon; and
- realising a functional coupling layer (10) above said substrate of single crystal silicon.

According to the invention, said step of realising a functional coupling layer comprises a step of realising a corrugated portion of said semiconductive substrate, said corrugated portion having the function of a functional coupling layer.

In particular, according to the invention, said step of realising said corrugated portion comprises a step of defining a plurality of microstructures in said layer of single crystal silicon.

According to another embodiment of the invention, said step of epitaxial regrowth is carried out so as to ensure a thickness of said layer of single crystal silicon suitable for said step of defining said plurality of microstructures.

Moreover, according to another embodiment of the invention, said step of defining said plurality of microstructures comprises a patterning step of said layer of single crystal silicon and a subsequent step of exposure and photolithographic etching.

According to a further embodiment of the invention, said step of defining said plurality of microstructures comprises a mechanical micromachining process.

Moreover, according to yet another embodiment of the invention, said step of epitaxial regrowth of said layer of single crystal silicon comprises a chemical deposition process in vapour phase.

Also, according to another embodiment of the invention, said step of epitaxial regrowth of said layer of single crystal silicon comprises a molecular beam epitaxy process.

According to the invention, said definition step realises said plurality of microstructures shaped like an inverse pyramid.

In particular, according to this embodiment of the invention, said definition step realises said plurality of microstructures shaped like a rectilinear pyramid with a square base formed by the planes of the family 111 arranged symmetrically around a central axis having its centre coinciding with a centre of symmetry of a base of said rectilinear pyramid.

Moreover, according to another embodiment of the invention, said step of realising a functional coupling layer further comprises a step of formation of a porous layer above said substrate of single crystal silicon.

According to this embodiment of the invention, said step of formation of said porous layer comprises an electrochemical etching process that converts a surface portion of said substrate of single crystal silicon into a layer of porous silicon suitable for realising said porous layer.

In particular, according to this embodiment of the invention, said step of formation of said porous layer comprises a step of formation of a layer of silicon with bubbles in an intermediate region of said substrate of single crystal silicon through a step of implantation of noble gases or Oxygen and subsequent heat treatment, said step of implantation and subsequent heat treatment converting said intermediate portion of substrate of single crystal silicon into said layer of silicon with bubbles suitable for realising said porous layer.

Moreover, according to an embodiment of the invention, said step of formation of said porous layer realises a porous layer having a different porosity between a surface area thereof positioned at said layer of single crystal silicon and a bottom area thereof positioned in a position opposite said layer of single crystal silicon.

According to this embodiment of the invention, said step of formation of said porous layer realises a porous layer having said surface area with a porosity equal to 40%-45% and a thickness of the order of a few nanometres and said bottom area with a greater porosity and thickness than said surface area.

Moreover, according to this embodiment of the invention, said step of formation of said porous layer realises a porous layer having said bottom area with a porosity equal to 60% and a thickness equal to 10 microns.

According to another embodiment of the invention, said step of realising said corrugated portion of said semiconductive substrate is carried out before said step of formation of said porous layer, said porous layer and said layer of single crystal silicon both having a corrugated shape and forming said functional coupling layer of said semiconductive substrate.

According to an embodiment of the invention, in said step of formation of said porous layer, a layer of silicon with bubbles is made in an intermediate region, near to the surface, of said substrate of single crystal silicon through a step of ionic implantation of nobles gases or oxygen and subsequent heat treatment, said step of implantation and subsequent heat treatment converting said intermediate portion of said substrate of single crystal silicon into said layer of silicon with bubbles suitable for realising said porous layer.

According to this embodiment of the invention, said step of implantation and subsequent heat treatment further defines a first and a second portion of said substrate of single crystal silicon, separated from said layer of silicon with bubbles and wherein said step of realising said corrugated portion comprises a step of defining a plurality of microstructures in said first portion of said substrate of single crystal silicon. Namely, said step of implantation and subsequent heat treatment realises said layer of silicon with bubbles with a high density of bubbles.

According to an embodiment of the invention, said step of implantation is carried out at a surface portion of said substrate of single crystal silicon.

According to another embodiment of the invention, said step of implantation is carried out at a bottom portion of said substrate of single crystal silicon.

Moreover, according to the invention, the manufacturing process further comprises an epitaxial growth step of a surface layer directly above said functional coupling layer.

According to the invention, said epitaxial growth step of said surface layer comprises an epitaxial growth step of a semiconductive material alternative to silicon.

In particular, said epitaxial growth step of said surface layer comprises an epitaxial growth step of a material chosen from silicon carbide, gallium nitride, gallium arsenide, zinc selenide and silicon-germanium.

According to an embodiment of the invention, said epitaxial growth step of said surface layer takes place after a further epitaxial growth step of a further silicon buffer layer made between said porous layer and said surface layer.

Moreover, according to another embodiment of the invention, said epitaxial growth step of said surface layer is carried out at least for a suitable thickness such as to allow the integration of electronic and/or optoelectronic devices into said semiconductive substrate.

Namely, said epitaxial growth step of said surface layer is continued for a thickness greater than said suitable thickness to realise a self-supporting semiconductive substrate of large size and in that it further comprises a step of partial removal of said substrate of single crystal silicon of a different type with respect to said surface layer.

In particular, according to this embodiment of the invention, said partial removal step takes place by abrasion.

According to another embodiment of the invention, said partial removal step takes place by etching.

Finally, according to yet another embodiment of the invention, the manufacturing process further comprises a high temperature growth step of a high quality bulk substrate of large size, suitable for subsequently realising electronic and/or optoelectronic devices.

The characteristics and advantages of the semiconductive substrate and of the corresponding manufacturing process according to the invention shall become clear from the following description of an embodiment thereof, given for indicating and not limiting purposes with reference to the attached drawings.

### Brief description of the drawings

In such drawings:
Figure 1 schematically shows an embodiment of a semiconductive substrate according to the invention;
Figure 2A schematically shows a semiconductive substrate being not part of the present invention;
Figure 2B shows an enlarged view of a detail of the semiconductive substrate of Figure 2A;
Figures 3A-3D show the semiconductive substrate of Figure 1 in different steps of the manufacturing process according to the invention;
Figures 4A and 4B schematically show the mechanism for reducing the defects during a heteroepitaxy process using the substrate of Figures 1 and 2;
Figure 5 shows a further embodiment of the semiconductive substrate according to the invention;

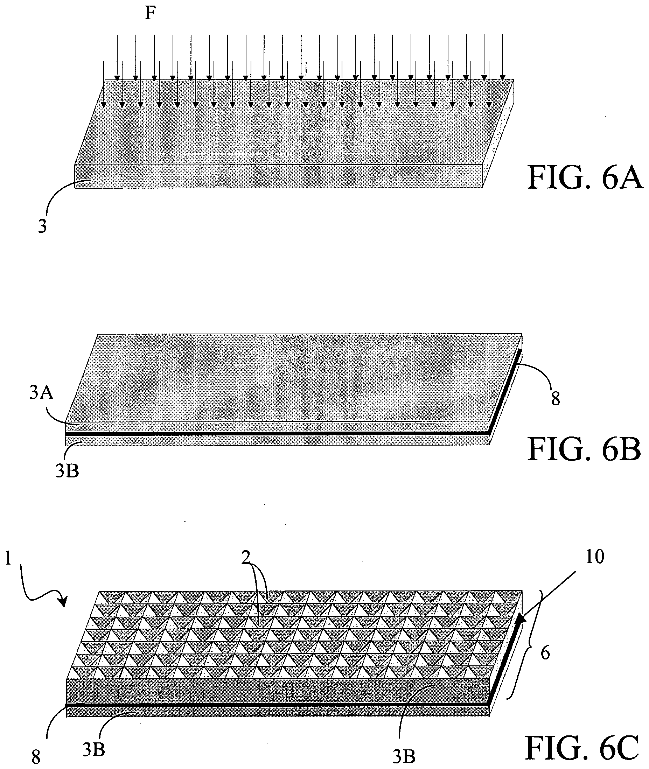

Figures 6A-6B show the semiconductive substrate according to the invention in different steps of the manufacturing process of the porous layer obtained through ionic implantation;
Figure 6C shows the semiconductive substrate according to the invention comprising a porous layer obtained through ionic implantation and a subsequent corrugation of its surface;
Figures 7A-7D and 8A-8C show the semiconductive substrate of

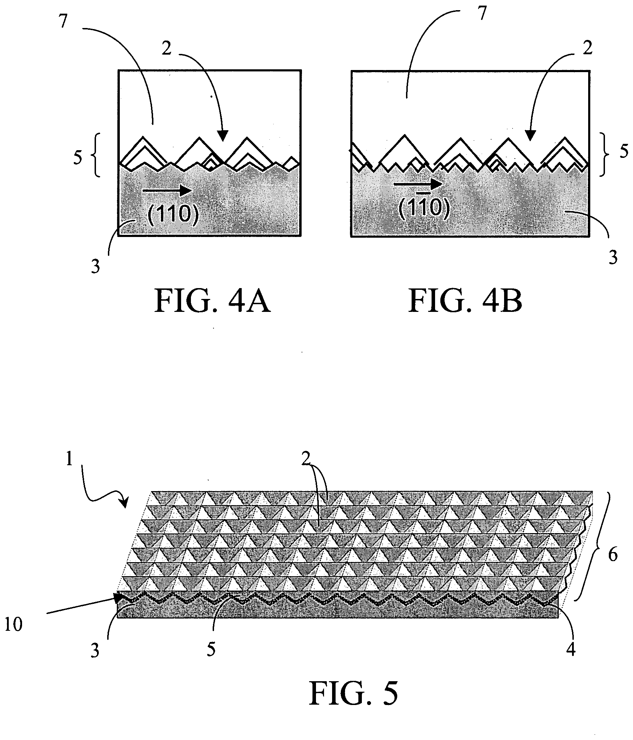

Figure 5 in different steps of the manufacturing.

### Detailed description

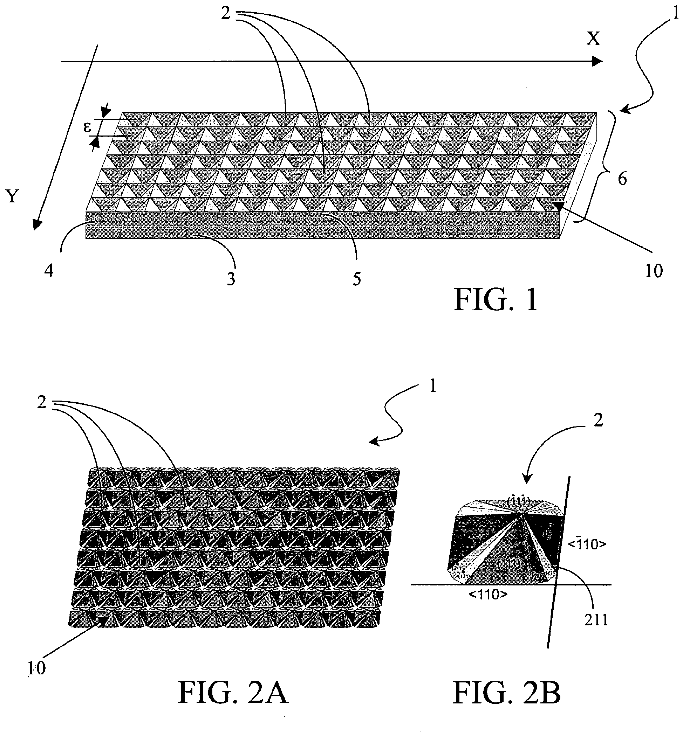

With reference to such figures, and in particular to Figures 1 and 2A, a semiconductive substrate is illustrated hereafter, wholly indicated with 1.

In particular, the semiconductive substrate 1 comprises at least one substrate 3, in particular of single crystal silicon, and an overlying layer of single crystal silicon 5 and it comprises at least one functional coupling layer 10 suitable for reducing the defects linked to the differences in the materials used.

In an embodiment of the semiconductive substrate according to the invention, such a functional coupling layer 10 is made through at least one corrugated portion 6 made in such a layer 5 of single crystal silicon, substantially suitable for reducing the defects linked to the differences in lattice constant of the materials used. The functional coupling layer 10 is thus a layer capable of creating a bridge or join between the different layers within the semiconductive substrate 1 according to the invention, in particular also comprising semiconductor materials alternative to silicon.

It should be noted that such a layer 5 of single crystal silicon in its most general form is a surface portion of the substrate 3 of single crystal silicon.

The corrugated portion 6 comprises a plurality of microstructures 2, nanometrically defined in a surface portion thereof.

In a preferred embodiment of the semiconductive substrate 1 according to the invention, such microstructures 2 are equidistant according to at least one direction between a first and a second direction of extension of the semiconductive substrate 1, indicated in Figure 1 as X and Y. In other words, the substrate is corrugated according to both of such main directions of extension X and Y, in a symmetrical manner.

It should be noted that it is not only the presence but also the particular configuration of the microstructures 2 that allows the planar defects due to the differences in lattice constant of the materials used, in particular semiconductor materials alternative to silicon, to be reduced.

In particular, Figure 1 shows an embodiment of the semiconductive substrate 1 comprising a plurality of microstructures 2 having the form of an inverse pyramid-shaped recess. More specifically, each microstructure 2 has a structure shaped like a rectilinear pyramid with a square base formed from the planes of the family 111 arranged symmetrically around a central axis having its centre coinciding with the centre of symmetry of a base of such a pyramid-shaped structure, where by family of planes a group of planes with the same superficial atomic configurations is intended.

Figure 2A, on the other hand, shows a semiconductive substrate 1 being not part of the present invention and comprising a plurality of microstructures 2, projecting from a plane defined by the substrate 3 of single crystal silicon, in particular shaped like a pyramid. In particular, each pyramid, shown in greater detail in Figure 2B, has a symmetrical diamond-shaped structure, formed by the planes of the family 111 (indicated as main planes with reference to a base plane 110) and of the family 211 (indicated as secondary planes) arranged around a central axis having its centre coinciding with the centre of symmetry of a base of such a diamond-shaped structure. It is worth emphasising the fact that, observed along one of the two main directions X or Y, the pyramids of Figure 2A have the same geometry as the recesses of Figure 1.

Such a semiconductive substrate 1, thanks to the presence of the corrugated portion 6 that realises the functional coupling layer 10, thus allows the defects linked to the differences in lattice constant of the materials used to be reduced or even eliminated, in this way allowing semiconductor materials alternative to silicon to be used.

Advantageously according to the invention, the corrugated portion 6 has a symmetrical progression in the two main directions X and Y of extension of the semiconductive substrate 1, in this way ensuring isotropic behaviour of the substrate itself.

It is also possible to provide the functional coupling layer 10 with a porous layer 4 substantially suitable for reducing the stress caused by the differences between the thermal expansion coefficients of the materials used. In this case, the layer 5 of single crystal silicon is made above such a porous layer 4.

In particular, the porous layer 4 is suitable for reducing the stress caused by the differences in heat expansion coefficient of the materials realising up the semiconductive substrate 1 and is essentially in the form of a layer of porous silicon (also indicated as PS) made above a silicon substrate. Alternatively, it is possible to realise the porous layer 4 through a layer with bubbles obtained thanks to the use of ionic implantation of noble gases or of oxygen.

The functional coupling layer 10 comprising the porous layer 4 thus also acts as a buffer layer capable of overcoming the problems linked to the different heat expansion coefficients of the materials used. In other words, such a functional coupling layer 10 realises an interface between the layers made from different materials.

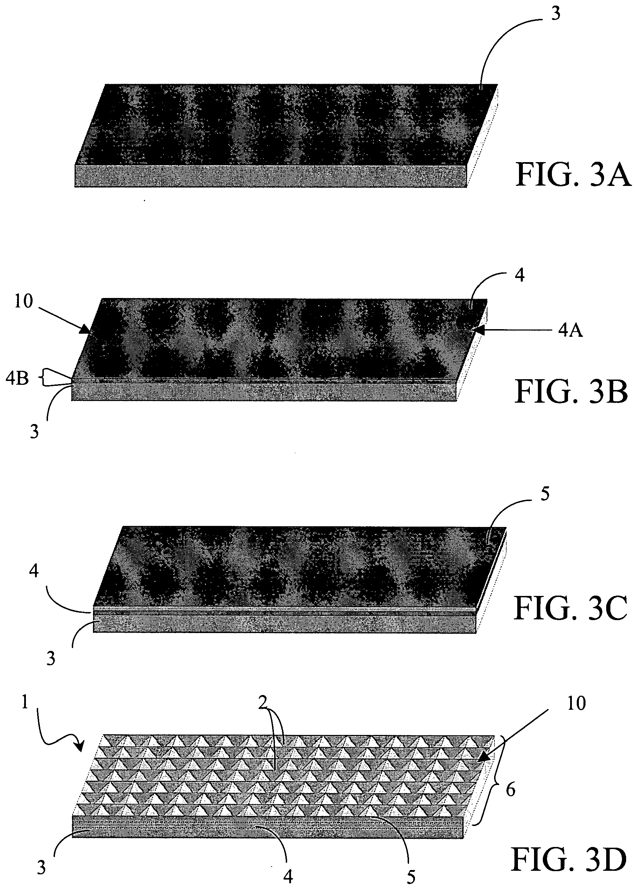

In an alternative embodiment of the semiconductive substrate 1, the layer 4 of porous silicon (PS) has a different porosity between a surface area thereof, corresponding to a top surface 4A (where the layer 5 of single crystal silicon is made) and a bottom area 4B thereof (positioned in a position opposite such a layer 5), as illustrated in Figure 3B.

In particular, the layer 4 of porous silicon (PS) comprising a surface area 4A having a porosity equal to 40%-45% with low thickness, of the order of a few nanometres, and a bottom area 4B having greater porosity and thickness, in particular respectively equal to 60% and to 10 microns.

Such a semiconductive substrate 1, thanks to the presence of the porous layer 4 in the functional coupling layer 10, thus allows the stress caused by the differences in heat expansion coefficient of the materials realising up the semiconductive substrate 1 to be reduced or even eliminated, in this way allowing semiconductor materials alternative to silicon to be used.

Advantageously, in accordance with the present invention, the semiconductive substrate 1 also comprises a surface layer 7, as illustrated in Figures 4A and 4B, in particular of silicon carbide made through heteroepitaxial growth above the layer 5 of single crystal silicon with the corrugated portion 6 so as to produce wafers and a seed of silicon carbide (SiC) capable of allowing the growth of a block of a size such as to exceed the current limitations of growth technology on silicon carbide (SiC), currently equal to diameters of from 75 to 100mm.

It is also possible to realise the semiconductive substrate 1 according to the invention by using a surface layer 7 of gallium nitride (GaN) grown on the layer 5 of single crystal silicon, in particular made with an epitaxial diamond growth.

In a preferred embodiment of the invention, the microstructures 2 within the corrugated portion 6 are suitably made in the layer 5 of single crystal silicon made above the porous layer 4.

In this case, as shall be made even clearer in the rest of the description, the combination of the porous layer 4 and of the special surface configuration of the structure of the semiconductive substrate 1, in particular the presence in the layer 5 of single crystal silicon of the corrugated portion 6, allows a surface layer 7 to be obtained through an epitaxial growth step free from the problems that known solutions suffer from.

Basically, the semiconductive substrate 1, according to this preferred embodiment of the invention, is suitable for combining the benefits of a corrugated substrate with those of a compliant substrate, in this way being a corrugated and compliant substrate.

Let us now see the manufacturing process according to the invention in greater detail, with reference in particular to Figures 3A-3D.

It should be noted that the process steps described hereafter do not form a complete process flow for the manufacture of integrated circuits. The present invention can be put into practice together with the manufacturing techniques currently used in the field, and only those steps of the process commonly used that are necessary for understanding the present invention are included.

Moreover, the figures that represent schematic views of portions of the semiconductive substrate 1 during the manufacturing are not drawn to scale, but instead are drawn so as to emphasise the important features of the invention.

Advantageously, according to the invention, the semiconductive substrate 1 comprises a functional coupling layer 10 in the form of a corrugated portion 6 having a plurality of microstructures 2 nanometrically defined, in particular a layer of single crystal silicon, such microstructures essentially comprising a plurality of recesses or pyramids suitable for reducing the defects caused by the differences in lattice constant of the materials used, in particular semiconductor materials alternative to silicon.

More specifically, such microstructures 2 are used to close the atomic dislocations introduced by the differences in lattice constant during an epitaxial growth step, in particular according to an axis (111) of the crystalline lattice of silicon.

Such closing takes place once a critical thickness Thcrit has been exceeded, such critical thickness being given by 2xh where h is the depth of the microstructures 2, said depth depending upon the geometric size thereof.

In this way, it is possible to close the atomic dislocations and begin a subsequent epitaxial growth step of a surface layer 7 so as to be free from the atomic dislocations described above. Advantageously according to the invention, such an epitaxial surface layer 7 can therefore be made from a semiconductive material alternative to silicon, without incurring the problems described in relation to the prior art.

In an alternative embodiment, the process according to the invention also comprises a step of realising a layer of porous silicon (PS) used as porous layer 4 to reduce the stress generated by the differences in expansion coefficient of the materials used, in particular semiconductor materials alternative to silicon, in this way realising a corrugated and compliant substrate.

Porous silicon (PS) is a material that has been widely researched, particularly in recent years, in the search for new materials for realising semiconductor devices.

In particular, it has been for example demonstrated that it is possible to reduce the stress of a layer of zinc-selenide (ZnSe) grown with chemical deposition in vapour phase on a layer of porous silicon (PS) just as there is a reduction in stress in the case of layers of gallium arsenide (GaAs) and of silicon-germanium (SiGe) grown epitaxially on a silicon/porous silicon/silicon (Si/PS/Si) substrate through metalorganic chemical deposition in vapour phase.

Regarding this, see the articles by C.C. Chang et al. having the title: "Characterization and fabrication of ZnSe epilayer on porous silicon substrate" Thin Solid Films 379 (2000) 287-291, by S. Saravanan et al. having the title: "Growth and characterization of GaAs epitaxial layer on Si/porous Si/Si substrate by chemical beam epitaxy" J. Appl. Phys. Vol. 89 (2001) pp. 5215-5219 No 9, by Yasuhiko Hayashi et al. having the title: "Thermal Stress Relaxation in GaAs layer on New thin Si layer over Porous Si Substrate Grown by metalorganic chemical vapor deposition" Jpn. J. Appl. Phys. Vol. 37 (1998) pp.L 1354-L1357 and by S.I. Romanov et al. having the title: "GeSi Films With Reduced Dislocation Density Grown by Molecular-Beam Epitaxy on Compliant Substrate Based on Porous Silicon", Applied Physics Letters, vol. 75, no. 26, 1999, pages 4118-4120. Moreover, it has been found that a further layer of silicon, for example with the function of a buffer layer, grown above a layer of porous silicon (PS) allows the stress caused by the differences in lattice constant between gallium arsenide (GaAs) and silicon as well as between silicon-germanium (SiGe) and silicon to be reduced.

In its most general form, the process for forming a semiconductive substrate 1 according to the invention thus comprises the following steps in sequence:
a) formation of a substrate 3, in particular of single crystal silicon, in the form of a flat plate;
b) epitaxial regrowth of a layer 5 of single crystal silicon above the substrate 3 of single crystal silicon, in particular through a chemical vapour deposition (CVD) process; alternatively, it is possible to use a molecular beam epitaxy (MBE) process; and
c) realising a functional coupling layer 10 above such a substrate 3 of single crystal silicon.

In particular, the step of realising the functional coupling layer 10 comprises a step of realising a corrugated portion 6 of the semiconductive substrate 1 through definition of a plurality of microstructures 2 in the layer 5 of single crystal silicon.

In this way, the process according to the invention realises a semiconductive substrate 1 with the corrugated portion 6 acting as functional coupling layer 10 or corrugated substrate, reducing or eliminating the defects linked to the differences in lattice constant of the materials used.

Alternatively, the step of realising the functional coupling layer 10 further comprises a step of formation of a porous layer 4 above such a substrate 3 of single crystal silicon.

In this case, the formation process comprises the following steps in sequence:
a) formation of a substrate 3 of single crystal silicon, in the form of a flat plate;
b) formation of the porous layer 4 acting as functional coupling layer 10, in particular of porous silicon (PS) above such a substrate 3 of single crystal silicon through an electrochemical etching process; in particular, such an electrochemical etching process converts a surface portion of the substrate 3 of single crystal silicon into the layer 4 of porous silicon (PS); and
c) epitaxial regrowth of a layer 5 of single crystal silicon above the layer 4 of porous silicon (PS), in particular through a chemical vapour deposition (CVD) process; alternatively, it is possible to use a molecular beam epitaxy (MBE) process.

In this way, the process according to the invention realises a semiconductive substrate 1 with the porous layer 4 in the functional coupling layer 10 acting as a compliant substrate, reducing or eliminating the stress caused by the differences in heat expansion coefficient of the materials used.

In a preferred embodiment of the invention, the process for forming a semiconductive substrate 1 according to the invention thus comprises the following steps in sequence:
a) formation of a substrate 3 of single crystal silicon, in the form of a flat plate, as schematically illustrated in Figure 3A;
b) formation of a porous layer 4, in particular of porous silicon (PS) above such a substrate 3 of single crystal silicon through an electrochemical etching process, as schematically illustrated in Figure 3B; in particular, such an electrochemical etching process converts a surface portion of the substrate 3 of single crystal silicon into the layer 4 of porous silicon (PS);
c) epitaxial regrowth of a layer 5 of single crystal silicon above the layer 4 of porous silicon (PS), in particular through a chemical vapour deposition (CVD) process, as schematically illustrated in Figure 3C; alternatively, it is possible to use a molecular beam epitaxy (MBE) process; and
d) realising a corrugated portion 6 of the semiconductive substrate 1 through definition of a plurality of microstructures 2 on the substrate as made by the previous steps and in particular in the layer 5 of single crystal silicon, as schematically illustrated in Figure 3D.

In this way, the process according to the invention realises a semiconductive substrate 1 with the functional coupling layer 10 made from the corrugated portion 6 and the porous layer 4 or corrugated and compliant substrate, reducing or eliminating all of the possible causes of defects that known substrates still suffer from.

It should be noted that the step of epitaxial regrowth of the layer 5 of single crystal silicon is carried out so as to ensure a thickness of such a layer 5 suitable for the subsequent step of defining the plurality of microstructures 2, in particular made through patterning of the layer 5 of single crystal silicon with subsequent step of exposure and photolithographic etching or else through a mechanical process such as micromachining.

Moreover, it is preferable to realise a layer 4 of porous silicon (PS) having a different porosity between a surface area thereof, corresponding to a top surface 4A where the layer 5 of single crystal silicon is made and a bottom area 4B thereof positioned in a position opposite such a layer 5, as illustrated in Figure 3B.

Experiments conducted by the Applicant itself have shown how a layer 4 of porous silicon (PS) comprising a surface area 4A having a porosity equal to 40%-45% with low thickness, of the order of a few nanometres, and a bottom area 4B having a greater porosity and thickness, in particular respectively equal to 60% and to 10 microns, is optimal.

The process for forming the semiconductive substrate 1 at this point comprises an epitaxial growth step for a suitable thickness of a surface layer 7, in particular of a semiconductive material alternative to silicon, directly above the structure obtained with the sequence of steps described above, or else with interposition of a buffer layer (not illustrated since it is conventional).

It is worth noting the fact that such a surface layer 7 is free from defects even if made from a semiconductive material alternative to silicon, thanks to the particular structure of the semiconductive substrate 1 that comprises the porous layer 4 and the corrugated portion 6 and that allows the problems linked to the differences in lattice constant and in expansion coefficients of the materials involved to be overcome.

In an embodiment of the semiconductive substrate 1 according to the invention, the layer 5 of single crystal silicon comprises a plurality of microstructures 2 each shaped like an inverted pyramid with a square base, as illustrated in Figure 3D.

It can immediately be seen how such microstructures 2 are able to reduce the defects linked to the atomic dislocations in all directions. Indeed, such defects increase perpendicularly to the side faces of the pyramids forming the microstructures 2, arranged according to the directions (111) and therefore, through the epitaxial growth of the surface layer 7 having a thickness equal to at least double the height of the pyramids forming the microstructures 2, as schematically illustrated in Figures 4A and 4B, it is possible to close the atomic dislocations and obtain a semiconductive substrate 1 having a surface layer 7 without defects linked to the atomic dislocations of the different materials used and therefore suitable for realising a layer of a semiconductive material alternative to silicon.

It should be noted that such a surface layer 7 can have a thickness of a few microns and that the semiconductive substrate 1 thus obtained can be used to realise electronic or optoelectronic devices.

It is also possible to use a surface layer 7 obtained through a longer-lasting epitaxial growth, in this way realising a self-supporting semiconductive substrate of large size, which can thereafter be partially removed by lapping or etching of all of the substrate of a different type with respect to the surface layer 7.

Furthermore, it is possible to introduce the semiconductive substrate 1 thus obtained into a CVD reactor for the high-temperature growth of a high-quality substrate bulk of large size, suitable for subsequently realising electronic or optoelectronic devices.

The semiconductive substrate 1 can also be obtained through an alternative embodiment of the formation process according to the invention, comprising the following steps in sequence:
a) formation of a substrate 3, in particular of single crystal silicon, in the form of a flat plate;
b) definition on such a substrate 3 of a plurality of microstructures, through a photolithographic and mechanical process, as illustrated previously;
c) formation of a layer 4 of porous silicon (PS) above such a substrate 3 through an electrochemical etching process, as illustrated previously;
d) epitaxial regrowth of a layer 5 of single crystal silicon above the layer 4 of porous silicon (PS) for a predetermined thickness; and
e) epitaxial growth of a surface layer 7 directly above the structure obtained with the sequence of steps described above, or else with interposition of a buffer layer (not illustrated since it is conventional).

The semiconductive substrate 1 obtained with such a sequence of steps is schematically illustrated in Figure 5. In particular, it should be noted how the layer 4 of porous silicon (PS) and the layer 5 of single crystal silicon both have a corrugated shape and form the functional coupling layer 10 of the semiconductive substrate 1.

Also in this case, the semiconductive substrate 1 obtained has a reduction in stress due to the differences in heat expansion coefficient, thanks to the use of the layer 4 of porous silicon (PS) and to the closing of the atomic dislocations obtained from the surface layer 7 made above the corrugated portion 6.

Also in this case, the epitaxial growth of the surface layer 7 can be carried out so as to obtain a layer with a thickness of a few microns and a semiconductive substrate 1 thus able to be used to realise electronic or optoelectronic devices.

It is also possible to realise a surface layer 7 through a longer-lasting epitaxial growth, in this way obtaining a self-supporting semiconductive substrate of large size, which can thereafter be partially removed by lapping or etching.

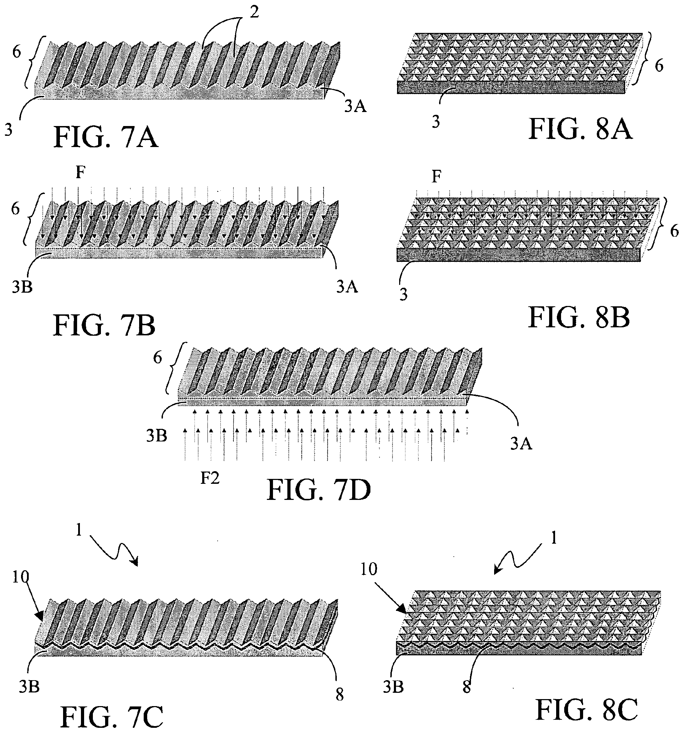

Furthermore, it is possible to introduce the semiconductive substrate 1 thus obtained into a CVD reactor for the high-temperature growth of a high-quality substrate bulk of large size, suitable for subsequently realising electronic or optoelectronic devices. In an alternative formation process the semiconductive substrate 1 is obtained through the following steps in sequence:
a) formation of a substrate 3 of single crystal silicon, in the form of a flat plate, as schematically illustrated in Figure 7A;
b) definition of a plurality of microstructures, in particular a plurality of microstructures 2 on a portion 3A of such a substrate 3 in this way obtaining a semiconductive substrate 1 with a corrugated portion 6 comprising the plurality of microstructures 2, as schematically illustrated in Figure 7A; and
c) formation of a layer 8 of silicon with bubbles, which can be considered as similar to a porous layer, in an intermediate region, preferably near to the surface a few tens of nanometres away, of such a substrate 3 through an implantation of a noble gas or of oxygen, as illustrated in Figure 7B, schematically indicated with F, and subsequent heat treatment, as illustrated in Figure 7C; in particular, such a step of implantation and subsequent heat treatment converts an intermediate portion of the substrate 3 of single crystal silicon into the layer 8 of silicon with bubbles, as schematically illustrated in Figure 7C, also defining a first 3A and a second portion 3B of the substrate 3, separated from such a layer 8 of silicon with bubbles, such a first portion 3A having the plurality of microstructures 2 and defining the corrugated portion 6 of the semiconductive substrate 1.

In particular, the semiconductive substrate 1 thus obtained comprises the layer 8 of silicon with bubbles and the corrugated portion 6 that form the functional coupling layer 10.

As seen previously, preferably, the layer 8 of silicon is suitably made with a high density of bubbles, so as to achieve the required reduction in stress linked o the differences in heat expansion of the materials used, the first corrugated portion 3A of the substrate 3 of single crystal silicon being used to reduce the defects linked to the differences in lattice constant.

The semiconductive substrate 1 in this case is also added to by a surface layer 7 grown above the structure obtained with the process steps described previously, such a surface layer 7 being essentially without defects at the temperature necessary for its growth step, even in the presence of large differences in lattice constant of the materials used and thus advantageously being able to be a layer of a semiconductive material alternative to silicon.

It should be highlighted that it is possible to carry out the implantation to form the layer 8 of silicon with bubbles at a surface portion of the substrate 3 of single crystal silicon (as indicated by the arrow F in Figure 7A) or else in the opposite direction (by carrying out the implant from the back), at a bottom portion of the substrate 3 of single crystal silicon (as indicated by the arrow F2 in Figure 7D).

As seen previously, the epitaxial growth of the surface layer 7 can be carried out so as to obtain a layer with a thickness of a few microns and a semiconductive substrate 1 thus able to be used to realise electronic or optoelectronic devices.

It is also possible to realise a surface layer 7 through a longer-lasting epitaxial growth, in this way obtaining a self-supporting semiconductive substrate of large size, which can thereafter be partially removed by lapping or etching.

Furthermore, it is possible to introduce the semiconductive substrate 1 thus obtained into a CVD reactor for the high-temperature growth of a high-quality substrate bulk of large size, suitable for subsequently realising electronic or optoelectronic devices.

In the process steps illustrated in figures 7A-7D, microstructures 2 having continuous progression along a direction of extension, in particular the second direction Y, of the semiconductive substrate 1, have been indicated. It is also possible to consider pyramid-shaped microstructures 2, as in the previous embodiments, the process comprising the identical sequence of steps indicated above, as illustrated in Figures 8A-8C.

Basically, the semiconductive substrate obtained according to the invention combines the benefits of corrugated substrates with those of compliant substrates and allows semiconductor materials alternative to silicon to be used, with the consequent advantages in terms of production costs, without however encountering the problems highlighted in relation to the prior art, the defects linked to the differences in lattice constant and in heat expansion coefficient of the materials used being eliminated thanks to the use of the porous layer 4 and of the plurality of microstructures 2.

In particular, such a semiconductive substrate 1 can be used for heteroepitaxy of materials with large differences in the lattice constant (10-20%). In a preferred embodiment of the invention, the formation process of the semiconductive substrate 1 is used to realise an epitaxy of silicon carbide (SiC) 3C on silicon, diamond on silicon (difference 50%) and gallium nitride (GaN) on silicon or on Al2O3.

Advantageously according to the invention, the semiconductive substrate 1 allows a wafer and a seed of a semiconductive material alternative to silicon, for example of silicon carbide (SiC) to be produced, which is able to allow the growth of a block of a size such as to overcome the drawbacks of current technology of growth on semiconductor materials alternative to silicon, in particular, in the case of silicon carbide (SiC), limited to diameters of from 75 to 100mm.

In conclusion, advantageously according to the invention, a semiconductive substrate is obtained that allows the growth of high-quality heteroepitaxial layers on a structure of single crystal silicon with a functional coupling layer 10 comprising a corrugated portion and a porous layer capable of eliminating the defects linked to the differences in lattice constant and in heat expansion coefficient of the materials used and allowing the use of semiconductor materials alternative to silicon.

## Claims

1. Semiconductive substrate (1) suitable for realising electronic and/or optoelectronic devices of the type comprising at least one substrate (3) of single crystal silicon, and an overlying layer of single crystal silicon (5), **characterised in that** said layer of single crystal silicon (5) comprises at least one functional coupling layer (10) comprising a corrugated portion (6) with a plurality of microstructures (2) shaped like an inverse pyramid, and **in that** said semiconductive substrate (1) further comprises a surface layer (7) made from a semiconductive material alternative to silicon above said layer of single crystal silicon (5) with said corrugated portion (6), said microstructures (2) of said corrugated portion (6) being suitable for reducing the defects linked to the differences in the materials used alternative to silicon by closing the atomic dislocations introduced by the differences in lattice constant.

2. Semiconductive substrate (1) according to claim 1, **characterised in that** said microstructures (2) are shaped like a rectilinear pyramid with a square base formed by the planes of the family 111 arranged symmetrically around a central axis having its centre coinciding with a centre of symmetry of a base of said rectilinear pyramid.

3. Semiconductive substrate (1) according to any one of claims 1 or 2, **characterised in that** said functional coupling layer (10) further comprises a porous layer (4), said layer of single crystal silicon (5) being made above said porous layer (4) which is suitable for reducing stress caused by the differences between thermal expansion coefficients of the materials used alternative to silicon.

4. Semiconductive substrate (1) according to claim 3, **characterised in that** said surface layer (7) is made above said porous layer (4).

5. Semiconductive substrate (1) according to claim 4, **characterised in that** it further comprises a silicon buffer layer made between said functional coupling layer (10) and said surface layer (7).

6. Semiconductive substrate (1) according to any of the preceding claims, **characterised in that** said surface layer (7) is made from a material chosen from silicon carbide, gallium nitride, gallium arsenide, zinc selenide and silicon-germanium.

7. Semiconductive substrate (1) according to claim 3, **characterised in that** said porous layer (4) comprises a layer of porous silicon (PS) or a layer of silicon with bubbles (8).

8. Manufacturing process of a semiconductive substrate (1) suitable for realising electronic and/or optoelectronic devices and comprising the steps of:
- formation of a substrate (3) of single crystal silicon;
- epitaxial regrowth of a layer of single crystal silicon (5) above said substrate of single crystal silicon (3);
- realising a functional coupling layer (10) above said substrate of single crystal silicon (3); and
- epitaxial growth of a surface layer (7) of a semiconductive material alternative to silicon above said layer of single crystal silicon (5);
wherein said step of realising a functional coupling layer (10) comprises a step of realising a corrugated portion (6) of said semiconductor substrate (1), said corrugated portion (6) comprising a plurality of microstructures (2) shaped like an inverse pyramid in said layer (5) of single crystal silicon and suitable for reducing the defects linked to the differences in the materials used alternative to silicon by closing the atomic dislocations introduced by the differences in lattice constant.

9. Manufacturing process of a semiconductive substrate (1) according to claim 8, wherein said realisation step realises said plurality of microstructures (2) shaped like a rectilinear pyramid with a square base formed by the planes of the family 111 arranged symmetrically around a central axis having its centre coinciding with a centre of symmetry of a base of said rectilinear pyramid.

10. Manufacturing process of a semiconductive substrate (1) according to claim 8, wherein said step of epitaxial regrowth of said layer of single crystal silicon (5) comprises a chemical deposition process in vapour phase or a molecular beam epitaxy process.

11. Manufacturing process of a semiconductive substrate (1) according to any one of claims 8-10, wherein said step of realising a functional coupling layer (10) further comprises a step of formation of a porous layer (4) above said substrate of single crystal silicon (3).

12. Manufacturing process of a semiconductive substrate (1) according to claim 11, wherein said step of realising said corrugated portion (6) is carried out before said step of formation of said porous layer (4), said porous layer (4) and said layer of single crystal silicon (5) both having a corrugated shape.

13. Manufacturing process of a semiconductive substrate (1) according to claim 12, wherein said step of formation of said porous layer (4) comprises an electrochemical etching process that converts a surface portion of said substrate of single crystal silicon (3) into a layer of porous silicon suitable for realising said porous layer (4).

14. Manufacturing process of a semiconductive substrate (1) according to claim 12, wherein said step of formation of said porous layer (4) comprises a step of formation of a layer of silicon with bubbles (8) in an intermediate region of said substrate of single crystal silicon (3) through a step of implantation of noble gases or Oxygen and subsequent heat treatment, said step of implantation and subsequent heat treatment converting said intermediate portion of substrate of single crystal silicon (3) into said layer of silicon with bubbles (8) suitable for realising said porous layer (4).

15. Manufacturing process of a semiconductive substrate (1) according to claim 8, wherein said epitaxial growth step of said surface layer (7) comprises an epitaxial growth step of a material chosen from silicon carbide, gallium nitride, gallium arsenide, zinc selenide and silicon-germanium.

## Patentansprüche

1. Halbleitendes Substrat (1), das zum Realisieren von elektronischen und/oder optoelektronischen Vorrichtungen des Typs geeignet ist, der mindestens ein Substrat (3) aus Einkristallsilizium und eine darüber liegende Schicht von Einkristallsilizium (5) umfasst, **dadurch gekennzeichnet, dass** die Schicht von Einkristallsilizium (5) mindestens eine funktionale Verbindungschicht (10) umfasst, die einen gewellten Teil (6) mit mehreren Mikrostrukturen (2) enthält, die wie eine umgekehrte Pyramide geformt sind, und dadurch, dass das halbleitende Substrat (1) ferner eine Oberflächenschicht (7) umfasst, die aus einem halbleitenden Material alternativ zu Silizium hergestellt ist, oberhalb der Schicht von Einkristallsilizium (5) mit dem gewellten Teil (6), wobei die Mikrostrukturen (2) des gewählten Teils (6) sich zum Reduzieren der Defekte eignen, die mit den Unterschieden in den Materialien verbunden sind, welche alternativ zu Silizium verwendet werden, durch Schließen der atomaren Versetzungen, die durch die Differenzen in der Gitterkonstante eingeführt wurden.

2. Halbleitendes Substrat (1) nach Anspruch 1, **dadurch gekennzeichnet, dass** die Mikrostrukturen (2) wie eine geradlinige Pyramide mit einer quadratischen Basis geformt sind, die durch die Ebenen der Familie 111 gebildet wird, welche rund um eine Mittelachse angeordnet ist, bei der ihr Zentrum mit einem Symmetriezentrum einer Basis der geradlinigen Pyramide zusammenfällt.

3. Halbleitendes Substrat (1) nach einem der Ansprüche 1 oder 2, **dadurch gekennzeichnet, dass** die funktionale Verbindungsschicht (10) ferner eine poröse Schicht (4) umfasst, wobei die Schicht aus Einkristallsilizium (5) oberhalb der porösen Schicht (4) hergestellt ist, die sich zum Reduzieren von Spannungen eignet, die durch die Differenzen zwischen thermischen Ausdehnungskoeffizienten der Materialien verursacht werden, die alternativ zu Silizium verwendet werden.

4. Halbleitendes Substrat (1) nach Anspruch 3, **dadurch gekennzeichnet, dass** die Oberflächenschicht (7) oberhalb der porösen Schicht (4) hergestellt ist.

5. Halbleitendes Substrat (1) nach Anspruch 4, **dadurch gekennzeichnet, dass** es ferner eine Siliziumpufferschicht umfasst, die zwischen der funktionalen Verbindungsschicht (10) und der Oberflächenschicht (7) hergestellt ist.

6. Halbleitendes Substrat (1) nach einem der vorherigen Ansprüche, **dadurch gekennzeichnet, dass** die Oberflächenschicht (7) aus einem Material hergestellt ist, das aus Siliziumkarbid, Galliumnitrid, Galliumarsenid, Zinkselenid und Silizium-Germanium ausgewählt wird.

7. Halbleitendes Substrat (1) nach Anspruch 3, **dadurch gekennzeichnet, dass** die poröse Schicht (4) eine Schicht aus porösem Silizium (PS) oder eine Schicht aus Silizium mit Blasen (8) umfasst.

8. Herstellungsprozess für ein halbleitendes Substrat (1), das sich zum Realisieren von elektronischen und/oder optoelektronischen Vorrichtungen eignet und die folgenden Schritte umfasst:
- Bildung eines Substrats (3) aus Einkristallsilizium;
- epitaxiales Nachwachsen einer Schicht von Einkristallsilizium (5) oberhalb des Substrats aus Einkristallsilizium (3);
- Realisieren einer funktionalen Verbindungsschicht (10) oberhalb des Substrats aus Einkristallsilizium (3); und
- epitaxiales Wachstum einer Oberflächenschicht (7) aus einem halbleitenden Material alternativ zu Silizium oberhalb der Schicht aus Einkristallsilizium (5);
wobei der Schritt des Realisierens einer funktionalen Verbindungsschicht (10) einen Schritt des Realisierens eines gewellten Teils (6) des Halbleitersubstrats (1) umfasst, wobei der gewellte Teil (6) mehrere Mikrostrukturen (2) enthält, die wie eine umgekehrte Pyramide in der Schicht (5) aus Einkristallsilizium geformt sind und sich zum Reduzieren der Defekte eignen, die mit den Unterschieden in den Materialien verbunden sind, welche alternativ zum Silizium verwendet werden, durch Schließen der atomaren Versetzungen, die durch die Unterschiede in der Gitterkonstante eingeführt werden.

9. Herstellungsprozess eines halbleitenden Substrats (1) nach Anspruch 8, wobei der Realisirungsschritt die mehreren Mikrostrukturen (2) realisiert, die wie eine geradlinige Pyramide geformt sind, mit einer quadratischen Basis, die durch die Ebenen der Familie 111 gebildet wird, welcher symmetrisch zu einer Mittelachse angeordnet ist, bei der ihr Zentrum mit einem Symmetriezentrum einer Basis der geradlinigen Pyramide zusammenfällt.

10. Herstellungsprozess eines halbleitenden Substrats (1) nach Anspruch 8, wobei der Schritt des epitaxialen Nachwachsens der Schicht aus Einkristallsilizium (5) einen chemischen Abscheidungsprozess in einer Dampfphase oder einen Molekülstrahl-Epitaxieprozess umfasst.

11. Herstellungsprozess eines halbleitenden Substrats (1) nach einem der Ansprüche 8-10, wobei der Schritt des Realisierens einer funktionalen Verbindungsschicht (10) ferner einen Schritt der Bildung einer porösen Schicht (4) oberhalb des Substrats aus Einkristallsilizium (3) umfasst.

12. Herstellungsprozess eines halbleitenden Substrats (1) nach Anspruch 11, wobei der Schritt des Realisierens des gewellten Teils (6) vor dem Schritt der Bildung der porösen Schicht (4) ausgeführt wird, wobei die poröse Schicht (4) und die Schicht aus Einzelkristallsilizium (5) beide einer gewellte Form haben.

13. Herstellungsprozess eines halbleitenden Substrats (1) nach Anspruch 12, wobei der Schritt der Bildung der porösen Schicht (4) einen elektrochemischen Ätzprozess umfasst, der einen Oberflächenteil des Substrats aus Einkristallsilizium (3) in eine Schicht aus porösem Silizium umwandelt, die sich zum Realisieren der porösen Schicht (4) eignet.

14. Herstellungsprozess eines halbleitenden Substrats (1) nach Anspruch 12, wobei der Schritt der Bildung der porösen Schicht (4) einen Schritt der Bildung einer Siliziumschicht mit Blasen (8) in einer Zwischenregion des Substrats aus Einkristallsilizium (3) durch einen Schritt der Implantierung von Edelgasen oder Sauerstoff und anschließender Wärmebehandlung umfasst, wobei der Schritt der Implantierung und die anschließende Wärmebehandlung den Zwischenteil des Substrats aus Einkristallsilizium (3) in die Siliziumschicht mit Blasen (8) umwandeln, die sich zum Realisieren der porösen Schicht (4) eignet.

15. Herstellungsprozess eines halbleitenden Substrats (1) nach Anspruch 8, wobei der epitaxiale Wachstumsschritt der Oberflächenschicht (7) einen epitaxialen Wachstumsschritt eines Materials umfasst, das aus Siliziumkarbid, Galliumnitrid, Galliumarsenid, Zinkselenid und Silizium-Germanium ausgewählt wird.

## Revendications

1. Substrat semi-conducteur (1) approprié à la réalisation de dispositifs électroniques et/ou optoélectroniques du type comprenant au moins un substrat (3) en silicium monocristallin et une couche de recouvrement en silicium monocristallin (5), **caractérisé en ce que** la couche en silicium monocristallin (5) comprend au moins une couche de couplage fonctionnel (10) comprenant une partie ondulée (6) avec une pluralité de microstructures (2) ayant la forme d'une pyramide inversée, et **en ce que** le substrat semi-conducteur (1) comprend en outre une couche de surface (7) faite d'un matériau semi-conducteur autre que du silicium et placée sur la couche de silicium monocristallin (5) comprenant la partie ondulée (6), les microstructures (2) de la portion ondulée (6) étant appropriées à réduire les défauts liés aux différences de matériaux utilisés à la place du silicium en fermant les dislocations atomiques induites par les différences de constante de réseau.

2. Substrat semiconducteur (1) selon la revendication 1, **caractérisé en ce que** les microstructures (2) ont la forme d'une pyramide rectiligne à base carrée formée par les plans de la famille 111 disposés symétriquement autour d'un axe central dont le centre coïncide avec un centre de symétrie d'une base de la pyramide rectiligne.

3. Substrat semi-conducteur (1) selon l'une quelconque des revendications 1 ou 2, **caractérisé en ce que** la couche de couplage fonctionnel (10) comprend en outre une couche poreuse (4), la couche de silicium monocristallin (5) étant réalisée sur la couche poreuse (4) qui est appropriée à réduire les contraintes causées par les différences entres les coefficients d'expansion thermique des matériaux utilisés à la place du silicium.

4. Substrat semi-conducteur (1) selon la revendication 3, **caractérisé en ce que** la couche de surface (7) est réalisée sur la couche poreuse (4).

5. Substrat semiconducteur (1) selon la revendication 4, **caractérisé en ce qu'il** comprend en outre une couche tampon de silicium réalisée entre la couche de couplage fonctionnel (10) et la couche de surface (7).

6. Substrat semiconducteur (1) selon l'une quelconque des revendications précédentes, **caractérisé en ce que** la couche de surface (7) est réalisée dans un matériau choisi parmi le carbure de silicium, le nitrure de gallium, l'arséniure de gallium, le séléniure de zinc et le silicium-germanium.

7. Substrat semiconducteur (1) selon la revendication 3, **caractérisé en ce que** la couche poreuse (4) comprend une couche de silicium poreux (SiP) ou une couche de silicium avec des bulles (8).

8. Procédé de fabrication d'un substrat semi-conducteur (1) approprié à la réalisation de dispositifs électroniques et/ou optoélectroniques et comprenant les étapes consistant :
- à former un substrat (3) en silicium monocristallin ;
- à réaliser une recroissance épitaxiale d'une couche de silicium monocristallin (5) sur le substrat de silicium monocristallin (3);
- à réaliser une couche de couplage fonctionnel (10) sur le substrat de silicium monocristallin (3) ; et
- à réaliser une croissance épitaxiale d'une couche de surface (7) d'un matériau semi-conducteur autre que du silicium sur la couche de silicium monocristallin (5) ;
procédé dans lequel l'étape consistant à réaliser la couche de couplage fonctionnel (10) comprend une étape consistant à réaliser une partie ondulée (6) du substrat semiconducteur (1), laquelle partie ondulée (6) comprenant une pluralité de microstructures (2) ayant la forme d'une pyramide inversée dans la couche (5) en silicium monocristallin et étant aptes à réduire les défauts liés aux différences de matériaux utilisés à la place du silicium en fermant les dislocations atomiques induites par les différences de constante de réseau.

9. Procédé de fabrication d'un substrat semiconducteur (1) selon la revendication 8, dans lequel l'étape de réalisation réalise la pluralité de microstructures (2) ayant la forme d'une pyramide rectiligne à base carrée formée par les plans de la famille 111 disposés symétriquement autour d'un axe central dont le centre coïncide avec un centre de symétrie d'une base de la pyramide rectiligne.

10. Procédé de fabrication d'un substrat semiconducteur (1) selon la revendication 8, dans lequel l'étape consistant à réaliser une recroissance épitaxiale de la couche de silicium monocristallin (5) comprend un processus de dépôt chimique en phase vapeur ou un processus d'épitaxie par jet moléculaire.

11. Procédé de fabrication d'un substrat semiconducteur (1) selon l'une quelconque des revendications 8-10, dans lequel l'étape consistant à réaliser une couche de couplage fonctionnel (10) comprend en outre une étape consistant à former une couche poreuse (4) sur le substrat de silicium monocristallin (3).

12. Procédé de fabrication d'un substrat semiconducteur (1) selon la revendication 11, dans lequel l'étape consistant à réaliser la partie ondulée (6) est réalisée avant l'étape consistant à former la couche poreuse (4), la couche poreuse (4) et la couche de silicium monocristallin (5) ayant toutes deux une forme ondulée.

13. Procédé de fabrication d'un substrat semiconducteur (1) selon la revendication 12, dans lequel l'étape consistant à former la couche poreuse (4) comprend un processus de gravure électrochimique qui convertit une partie de surface du substrat en silicium monocristallin (3) en une couche de silicium poreux approprié à la réalisation de la couche poreuse (4).

14. Procédé de fabrication d'un substrat semiconducteur (1) selon la revendication 12, dans lequel l'étape consistant à former la couche poreuse (4) comprend une étape consistant à former une couche de silicium avec des bulles (8) dans une région intermédiaire du substrat de silicium monocristallin (3) à travers une étape consistant à implanter des gaz rares ou de l'oxygène et à réaliser ensuite un traitement thermique, laquelle étape d'implantation et de traitement thermique ultérieur convertissant la portion intermédiaire de substrat de silicium monocristallin (3) en couche de silicium avec des bulles (8) appropriée à réaliser la couche poreuse (4).

15. Procédé de fabrication d'un substrat semiconducteur (1) selon la revendication 8, dans lequel l'étape consistant à réaliser à la croissance épitaxiale de la couche de surface (7) comprend une étape de croissance épitaxiale d'un matériau choisi parmi le carbure de silicium, le nitrure de gallium, l'arséniure de gallium, le séléniure de zinc et le silicium-germanium.
